# EUROPEAN PATENT APPLICATION

(11) **EP 4 715 084 A1**
(43) Date of publication of application: **25.03.2026**
(21) Application number: 24810766.6
(22) Date of filing: 15.04.2024
(51) Int. Cl.: C23C 14/08, C23C 14/35, H01G 7/06, H01G 9/07, H01G 9/042, H01G 9/045, H10N 30/06, H10N 30/87, H10N 30/853

(54) **DIELECTRIC AND FUNCTIONAL ELEMENT**

(30) Priority: 19.05.2023 JP 2023083498
(71) Applicant: Panasonic Intellectual Property Management Co., Ltd., Kadoma-shi, Osaka 571-0057 (JP)
(72) Inventor: MORIMOTO, Kota, Kadoma-shi, Osaka 571-0057 (JP); TAKEUCHI, Hiroki, Kadoma-shi, Osaka 571-0057 (JP); KIKUCHI, Ryosuke, Kadoma-shi, Osaka 571-0057 (JP); AMII, Kei, Kadoma-shi, Osaka 571-0057 (JP)
(74) Representative: Grünecker Patent- und Rechtsanwälte PartG mbB
(86) International application number: PCT/JP2024/015007
(87) International publication number: WO 2024/241758

(57) **Abstract**

A dielectric contains an oxide containing hafnium and cerium. The molar ratio of the content of cerium to the sum of the content of hafnium and the content of cerium is greater than or equal to 0.031 and less than or equal to 0.052. The molar ratio of the content of oxygen to the sum of the content of hafnium and the content of cerium is greater than 0 and less than or equal to 1.50.

## Description

### Technical Field

The present disclosure relates to a dielectric and a functional element.

### Background Art

It is conventionally known that HfO₂ with a fluorite type structure changes its crystalline phase by adding another metal element to change its dielectric characteristics from a paraelectric to a ferroelectric. For example, NPL 1 states that HfO₂ to which elements such as Si, Al, Zr, and Y are added shows ferroelectricity.

NPL 2 states that a solid solution film represented by (Hf₁₋ₓCeₓ)O₂ shows ferroelectricity. In this film, x is in a range of 0.15 to 0.20.

### Citation List

### Non Patent Literature

NPL 1: M. H. Park et al., Adv. Mater. 2015, 27, 1811-1831
NPL 2: K. Hirai et al., Jpn. J. Appl. Phys. 2022, 61, SN1019

### Summary of Invention

### Technical Problem

An object of the present disclosure is to provide a novel dielectric suitable for use in a functional element such as a capacitor.

### Solution to Problem

The present disclosure provides a dielectric containing an oxide containing hafnium and cerium, wherein a molar ratio of a content of cerium to a sum of a content of hafnium and the content of cerium is greater than or equal to 0.031 and less than or equal to 0.052, and a molar ratio of a content of oxygen to the sum is greater than 0 and less than or equal to 1.50.

### Advantageous Effects of Invention

The present disclosure can provide a novel dielectric suitable for use in a functional element such as a capacitor.

### Brief Description of Drawings

[Fig. 1] Fig. 1 is a sectional view of an example of a functional element of the present disclosure.
[Fig. 2] Fig. 2 is a sectional view of another example of the functional element of the present disclosure.
[Fig. 3] Fig. 3 is a graph of a relation between polarization and electric field intensity in dielectric films according to Examples 1 to 3.
[Fig. 4] Fig. 4 is a graph of a relation between polarization and electric field intensity in dielectric films according to Comparative Examples 1 to 4.
[Fig. 5] Fig. 5 is a graph of X-ray diffraction patterns of dielectrics according to Examples 1 to 3.

### Description of Embodiments

### (Underlying Knowledge Forming Basis of the Present Disclosure)

In (Hf₁₋ₓCeₓ)O₂ described in NPL 2, the addition concentration x of Ce is 0.15 to 0.20. Ce in CeO₂ easily changes its valence between Ce⁴⁺ and Ce³⁺ depending on an ambient oxygen concentration. When a capacitor is produced using a dielectric containing HfO₂ with Ce added, for example, at the interface between the dielectric and an electrode, the valence of Ce is likely to change depending on an oxygen concentration in the electrode. When the valence of Ce fluctuates, an electron state around Ce cations changes, thus raising the possibility that the characteristics of the dielectric fluctuate. If the characteristics of the dielectric fluctuate, the characteristics of the capacitor that is constituted including the dielectric also fluctuate. Accordingly, inhibiting the fluctuations in the valence of Ce cations in the dielectric is desirable from the viewpoint of inhibiting the characteristic fluctuations of a functional element such as a capacitor and obtaining a chemically stable dielectric.

Given these circumstances, the present inventors have conducted intensive studies in order to improve, in a functional element including a dielectric containing an oxide containing hafnium and cerium, the chemical stability of the dielectric. Consequently, the present inventors have newly found that the chemical stability of the dielectric can be improved by adjusting the contents of hafnium, cerium, and oxygen to have a certain relation. Based on this new knowledge, the dielectric of the present disclosure has been devised.

### (Embodiment)

An embodiment of the present disclosure will be described below with reference to the drawings. However, the present disclosure is not limited to the following embodiment.

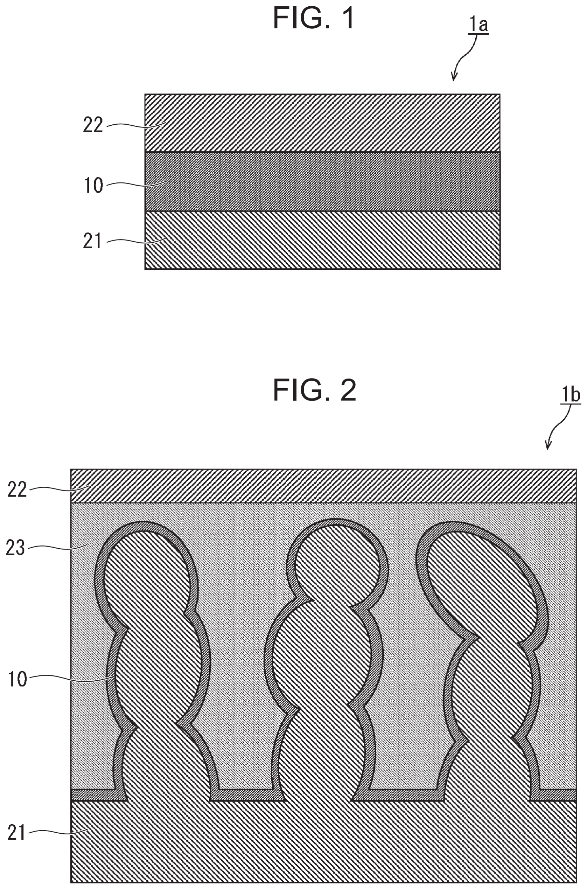

Fig. 1 is a sectional view of an example of a functional element 1a of the present disclosure. As shown in Fig. 1, the functional element 1a includes a dielectric 10. The dielectric 10 contains an oxide containing hafnium and cerium. The molar ratio of the content of cerium to the sum of the content of hafnium and the content of cerium is greater than or equal to 0.031 and less than or equal to 0.052, and the molar ratio of the content of oxygen to the sum is greater than 0 and less than or equal to 1.50. This configuration can improve the chemical stability of the dielectric 10. The dielectric 10 may contain Zr, which is contained in a precursor raw material of Hf or the like.

In the dielectric 10 according to the present embodiment, the element concentration of Ce contained in the dielectric 10 is reduced. Specifically, the molar ratio of the content of cerium to the sum of the content of hafnium and the content of cerium satisfies greater than or equal to 0.031 and less than or equal to 0.052. Thus, in the dielectric 10, the region in which the valence of Ce is likely to fluctuate can be reduced. That is, the dielectric 10 that is chemically stable can be obtained.

In addition, in the dielectric 10 according to the present embodiment, the molar ratio of the content of oxygen to the sum of the content of hafnium and the content of cerium satisfies greater than 0 and less than or equal to 1.50. That is, the concentration of oxygen contained in the dielectric 10 is maintained low. Thus, in the dielectric 10, the element concentration of Ce can be reduced. Consequently, in the dielectric 10, the region in which the valence of Ce is likely to fluctuate can be reduced. That is, the dielectric 10 that is chemically stable can be obtained.

The molar ratio of the content of cerium to the sum of the content of hafnium and the content of cerium in the dielectric 10 may satisfy greater than or equal to 0.031 and less than or equal to 0.050 or satisfy greater than or equal to 0.031 and less than or equal to 0.048. The molar ratio may satisfy greater than or equal to 0.035 and less than or equal to 0.052, satisfy greater than or equal to 0.040 and less than or equal to 0.052, satisfy greater than or equal to 0.045 and less than or equal to 0.052, or satisfy greater than or equal to 0.048 and less than or equal to 0.052.

The molar ratio of the content of oxygen to the sum of the content of hafnium and the content of cerium in the dielectric 10 may satisfy greater than or equal to 1.44 and less than or equal to 1.50. In this case, the region in which the valence of Ce is likely to fluctuate can be further reduced. Consequently, the dielectric 10 that is more chemically stable can be obtained. The molar ratio may satisfy greater than or equal to 1.44 and less than or equal to 1.47.

The dielectric 10 may have a composition represented by a composition formula Hf₁₋ₓCeₓO_{y}. In this composition formula, 0.031 ≤ x ≤ 0.052 and 0 < y ≤ 1.50 are satisfied. With this configuration, the chemical stability of the dielectric 10 can be improved.

The dielectric 10 may satisfy 0.031 ≤ x ≤ 0.050 or satisfy 0.031 ≤ x ≤ 0.048. The dielectric 10 may satisfy 0.035 ≤ x ≤ 0.052, satisfy 0.040 ≤ x ≤ 0.052, satisfy 0.045 ≤ x ≤ 0.052, or satisfy 0.048 ≤ x ≤ 0.052.

The dielectric 10 may satisfy 1.44 ≤ y ≤ 1.50. In this case, the region in which the valence of Ce is likely to fluctuate can be further reduced. Consequently, the dielectric 10 that is more chemically stable can be obtained. The dielectric 10 may satisfy 1.44 ≤ y ≤ 1.47.

The dielectric 10 may contain a crystalline phase having a fluorite type crystal structure. In addition, the dielectric 10 may be a polycrystalline film. With this configuration, the dielectric 10 easily shows ferroelectricity. Examples of the crystalline phase having a fluorite type crystal structure include an orthorhombic crystalline phase, a monoclinic crystalline phase, a tetragonal crystalline phase, and a cubic crystalline phase.

The dielectric 10 may contain the orthorhombic crystalline phase as the crystalline phase. The orthorhombic crystalline phase can have polarization in an out-of-plane direction. Thus, when the dielectric 10 contains the orthorhombic crystalline phase as the crystalline phase, the dielectric 10 easily shows ferroelectricity.

The dielectric 10 may have the monoclinic crystalline phase, the tetragonal crystalline phase, the cubic crystalline phase, and the orthorhombic crystalline phase. With this, the dielectric 10 easily shows ferroelectricity.

In an X-ray diffraction (XRD) pattern of the dielectric 10, 0.87 ≤ a/(a + b) ≤ 0.98 may be satisfied, in which a is a peak area of a diffraction peak attributed to reflection from a (111) plane of the orthorhombic crystalline phase in the X-ray diffraction pattern of the dielectric 10 and b is a peak area of a diffraction peak attributed to reflection from a (001) plane of the orthorhombic crystalline phase in the X-ray diffraction pattern of the dielectric 10. With this configuration, the dielectric 10 easily shows ferroelectricity.

The peak area a indicates the peak area of a diffraction peak observed near 2θ = 30.2° in the XRD spectrum. This peak is a diffraction peak attributed to reflection from the (111) plane of the orthorhombic crystalline phase. The peak area b indicates the area of a diffraction peak observed near 2θ = 35.4° in the XRD spectrum. This peak is a diffraction peak attributed to reflection from the (001) plane of the orthorhombic crystalline phase.

In the present disclosure, the expression "near 2θ = 30.2°" and the expression "near 2θ = 35.4°" mean "20 = 30.2 ± 0.5°" and "2θ = 35.4 ± 0.5°", respectively.

In the orthorhombic crystalline phase, when the (111) plane and the (001) plane exist, the dielectric 10 is likely to have polarization in the out-of-plane direction. With this, the dielectric 10 easily shows ferroelectricity. On the other hand, in the orthorhombic crystalline phase, when the (001) plane exists, a (010) plane is likely to coexist. When the (010) plane exists, the dielectric 10 is likely to have polarization in an in-plane direction and is less likely to have polarization in the out-of-plane direction. When the dielectric 10 contains the (001) plane of the orthorhombic crystalline phase, the dielectric also contains the (010) plane, and thus variations in dielectric characteristics are likely to occur. In the present embodiment, the dielectric 10 satisfies 0.87 ≤ a/(a + b) ≤ 0.98. With this configuration, the peak area of the diffraction peak attributed to reflection from the (001) plane is smaller than the peak area of the diffraction peak attributed to reflection from the

(111) plane. That is, in the orthorhombic crystalline phase, the existence ratio of the (001) plane is reduced compared to the existence ratio of the (111) plane. Along with this, in the orthorhombic crystalline phase, the existence ratio of the (010) plane can also be reduced. That is, when 0.87 ≤ a/(a + b) ≤ 0.98 is satisfied, the dielectric 10 in which the (010) plane is less likely to exist can be obtained, and thus the dielectric 10 easily shows ferroelectricity. The dielectric 10 may satisfy 0.90 ≤ a/(a + b) ≤ 0.98.

The peak area a and the peak area b can be determined as follows. XRD measurement is performed on the dielectric 10 to acquire an XRD pattern. On this XRD pattern, Peak Parameters processing is performed on desired peaks using analysis software Data Viewer from Malvern Panalytical Ltd. With this, the peak area a and the peak area b can be calculated. The desired peaks are the peak near 2θ = 30.2° and the peak near 2θ = 35.4°. The Peak Parameters processing is a function that can automatically calculate a net peak area. Note that in the calculation of the peak area a and the peak area b, neither peak fitting nor base line adjustment on a manual basis is performed.

The dielectric 10 may contain a solid solution of hafnium oxide and cerium oxide.

The method for producing the dielectric 10 is not limited to a particular method. The method for producing the dielectric 10 includes, for example, producing a film for the dielectric and crystallizing the film for the dielectric.

For the production of the film for the dielectric, for example, film forming methods such as RF magnetron sputtering, pulsed laser deposition (PLD), atomic layer deposition (ALD), chemical vapor deposition (CVD), mist CVD, the sol-gel method, the hydrothermal method, and the anodic oxidation method can be used. For the crystallization of the film for the dielectric, for example, methods such as rapid thermal anneal (RTA) can be used. With this, the dielectric 10 having crystallinity can be obtained.

By appropriately adjust the conditions in the production of the dielectric 10, the dielectric 10 satisfying the molar ratio of the content of oxygen to the sum of the content of hafnium and the content of cerium being greater than 0 and less than or equal to 1.50 can be obtained. For example, by appropriately adjusting an environment in film formation and an environment in rapid thermal anneal or appropriately selecting the material of electrodes in contact with the dielectric 10, the dielectric 10 satisfying the molar ratio being greater than 0 and less than or equal to 1.50 and the functional element 1a including this dielectric 10 can be obtained.

As shown in Fig. 1, the functional element 1a includes a first electrode 21, the dielectric 10, and a second electrode 22. The dielectric 10 is located between the first electrode 21 and the second electrode 22. The dielectric 10 is disposed in contact with the first electrode 21. The second electrode 22 may cover at least part of the dielectric 10. The first electrode 21 may be disposed on a support. The functional element 1a includes the dielectric 10, and thus the functional element 1a easily improves in chemical stability.

Fig. 2 is a sectional view of another example of the functional element of the present disclosure. A functional element 1b shown in Fig. 2 is configured in the same manner as in the functional element 1a except the part specifically described. The components of the functional element 1b the same as or corresponding to the components of the functional elements 1a are denoted by the same reference signs, and detailed descriptions thereof are omitted. The description about the functional element 1a also applies to the functional element 1b so long as there is no technical contradiction.

As shown in Fig. 2, in the functional element 1b, at least part of the first electrode 21 is porous. With this configuration, the surface area of the first electrode 21 easily increases. Such a porous structure can be formed by etching of metallic foil, sintering treatment of powder, or the like.

As shown in Fig. 2, for example, a film of the dielectric 10 is formed on the surface of porous parts of the first electrode 21. In this case, as a method for forming the film of the dielectric 10, atomic layer deposition (ALD) or chemical vapor deposition such as CVD and mist CVD can be employed.

The first electrode 21 may contain at least one selected from the group consisting of a metal, a conductive nitride, and a conductive oxide. Examples of the metal include Pt, Au, Al, Ta, and Zr. Examples of the conductive nitride include TiN and TaN. Examples of the conductive oxide include indium tin oxide (ITO), antimony tin oxide (ATO), and ZnO. The first electrode 21 desirably contains the metal. That is, the first electrode 21 desirably contains at least one selected from the group consisting of Pt, Au, Al, Ta, and Zr. The first electrode 21 may contain Al or may be Al.

The second electrode 22 may contain at least one selected from the group consisting of a metal, a conductive nitride, and a conductive oxide. Examples of the metal, examples of the conductive nitride, and examples of the conductive oxide are as described above.

The first electrode 21 and the second electrode 22 can be produced by a method such as RF magnetron sputtering, pulsed laser deposition (PLD), atomic layer deposition (ALD), chemical vapor deposition (CVD), mist CVD, the sol-gel method, the hydrothermal method, or vacuum vapor deposition.

In the functional elements 1a and 1b, an electrolyte 23 may be disposed between the first electrode 21 and the second electrode 22, or more specifically, between the dielectric 10 and the second electrode 22. The electrolyte 23 may be in contact with the second electrode 22. The electrolyte 23 may be in contact with the dielectric 10. In the functional element 1b, the electrolyte 23 is disposed, for example, so as to fill gaps around the porous parts of the first electrode 21.

The electrolyte 23 contains, for example, at least one selected from the group consisting of an electrolyte solution, a conductive polymer, and manganese oxide. Examples of the conductive polymer include polypyrrole, polythiophene, polyaniline, and derivatives of these. The electrolyte 23 may be a manganese compound such as manganese oxide. The electrolyte 23 may contain a solid electrolyte.

The functional elements 1a and 1b are not limited to particular elements. The functional elements 1a and 1b are, for example, at least one selected from the group consisting of a capacitor, an electro-optic element, a memory element, a transistor, a ferroelectric data storage, a piezoelectric element, and a pyroelectric element. For example, in these functional elements, the ferroelectricity of the dielectric 10 can be effectively utilized. The functional elements 1a and 1b are desirably at least one selected from the group consisting of a capacitor and a memory element.

The functional elements 1a and 1b are disposed in, for example, at least one selected from the group consisting of an actuator, an inkjet head, a gyro sensor, a vibration power generating element, a surface acoustic wave resonator, a film bulk resonator, a piezoelectric mirror, and a piezoelectric sensor. In this case, in the actuator and the like, a piezoelectric effect along with the ferroelectricity of the dielectric 10 can be effectively utilized.

### (Note)

The following techniques are disclosed by the above description.

### (Technique 1)

A dielectric containing an oxide containing hafnium and cerium, wherein
a molar ratio of a content of cerium to a sum of a content of hafnium and the content of cerium is greater than or equal to 0.031 and less than or equal to 0.052, and
a molar ratio of a content of oxygen to the sum is greater than 0 and less than or equal to 1.50.

According to Technique 1, the novel dielectric 10 suitable for use in a functional element such as a capacitor can be provided.

### (Technique 2)

The dielectric according to Technique 1, wherein the molar ratio of the content of oxygen to the sum is greater than or equal to 1.44 and less than or equal to 1.50.

According to Technique 2, the dielectric 10 that is more chemically stable can be obtained.

### (Technique 3)

The dielectric according to Technique 1 or 2, wherein the dielectric has a composition represented by a composition formula Hf₁₋ₓCeₓO_{y} and satisfies 0.031 ≤ x ≤ 0.052 and y ≤ 1.50.

### (Technique 4)

The dielectric according to Technique 3, wherein the dielectric satisfies 1.44 ≤ y ≤ 1.50.

### (Technique 5)

The dielectric according to any one of Techniques 1 to 4, wherein
the dielectric contains a crystalline phase having a fluorite type crystal structure, and
the dielectric is a polycrystalline film.

According to Technique 5, the dielectric 10 easily shows ferroelectricity.

### (Technique 6)

The dielectric according to any one of Techniques 1 to 5, wherein
the dielectric contains an orthorhombic crystalline phase, and
the dielectric satisfies 0.87 ≤ a/(a + b) ≤ 0.98 in an X-ray diffraction pattern of the dielectric, where
a is a peak area of a diffraction peak attributed to reflection from a (111) plane of the orthorhombic crystalline phase in the X-ray diffraction pattern, and
b is a peak area of a diffraction peak attributed to reflection from a (001) plane of the orthorhombic crystalline phase in the X-ray diffraction pattern.

According to Technique 6, the dielectric 10 easily shows ferroelectricity.

### (Technique 7)

A functional element including:
a first electrode;
a second electrode; and
the dielectric according to any one of Techniques 1 to 6, the dielectric being located between the first electrode and the second electrode.

According to Technique 7, the functional element 1a includes the dielectric 10, and thus the chemical stability of the functional element 1a easily improves.

### (Technique 8)

The functional element according to Technique 7, wherein at least part of the first electrode is porous.

According to Technique 8, the surface area of the first electrode 21 easily increases.

### (Technique 9)

The functional element according to Technique 7 or 8, wherein the first electrode contains at least one selected from the group consisting of a metal, a conductive nitride, and a conductive oxide.

### (Technique 10)

The functional element according to any one of Techniques 7 to 9, wherein the first electrode contains at least one selected from the group consisting of Pt, Au, Al, Ta, and Zr.

### (Technique 11)

The functional element according to any one of Techniques 7 to 10, wherein the first electrode contains Al.

According to Techniques 9 to 11, the dielectric 10 is included, and thus the chemical stability of the functional element 1a easily improves.

### (Technique 12)

The functional element according to any one of Techniques 7 to 11, further including an electrolyte located between the second electrode and the dielectric, wherein the electrolyte contains at least one selected from the group consisting of an electrolyte solution, a conductive polymer, and manganese oxide.

According to Technique 12, the chemical stability of the functional element 1b including the electrolyte easily improves.

### (Technique 13)

The functional element according to any one of Techniques 7 to 12, wherein the functional element is at least one selected from the group consisting of a capacitor, an electro-optic element, a memory element, a transistor, a ferroelectric data storage, a piezoelectric element, and a pyroelectric element.

According to Technique 13, a functional element effectively utilizing the ferroelectricity of the dielectric 10 can be provided.

### (Technique 14)

The functional element according to any one of Techniques 7 to 13, wherein
the dielectric is in contact with the first electrode, and
the second electrode covers at least part of the dielectric.

### EXAMPLES

The present disclosure will be described below in more detail based on examples. However, the present disclosure is not limited to the following examples.

### (Production of Sample)

As a base material, a Si(111) wafer was used. A buffer layer of ZrO₂ was formed on this base material. The thickness of the buffer layer was 60 nm. On this buffer layer, a Pt(111) film was epitaxially grown to form a thin film as a lower electrode. The thickness of this thin film was 150 nm. Thus, a substrate in which the lower electrode was formed on the base material was obtained.

Next, a film for a dielectric was formed on the lower electrode of the substrate by RF magnetron sputtering with HfO₂ and CeO₂ as targets. The sputtering time was adjusted such that the thickness of the dielectric became 10 nm to 30 nm. In sputtering, the environment of the substrate was maintained at a pressure condition of 2 Pa with argon gas occupying a volume of 100%. Note that the substrate was not heated.

Subsequently, the film for the dielectric was crystallized by rapid thermal anneal (RTA) to obtain a dielectric film. The environment in rapid thermal anneal was maintained at a pressure condition of one atmosphere with nitrogen gas and oxygen gas mixed at a desired ratio. The heat treatment in rapid thermal anneal was performed with a process including a temperature rise up to 750°C at a rate of 5°C/sec, holding at this temperature for 30 seconds, and natural cooling. Subsequently, a Au film having a thickness of 150 nm was formed on the dielectric film by vacuum vapor deposition to obtain a Au electrode as an upper electrode. The diameter of the Au electrode was 200 µm. Thus, samples according to Examples 1 to 3 and samples according to Comparative Examples 1 to 4 were produced.

### (Evaluation of Composition)

Using an X-ray photoelectron spectroscopic (XPS) apparatus JPS-9010TR manufactured by JEOL Ltd., the composition of the dielectric according to each sample was evaluated. First, the upper electrode was formed, and then X-ray photoelectron spectroscopy (XPS) was performed on the dielectric film according to each sample to acquire narrow spectra of the Hf4f orbital, the Ce3d orbital, and O1s orbital of the dielectric film according to each sample. Based on the obtained spectra, using analysis software SpecSurf attached to the above apparatus, the element concentration of each element contained in the dielectric film according to each sample was determined. Subsequently, using the obtained element concentration, the value of x and the value of y of the dielectric film according to each sample when the composition formula of the dielectric was assumed to be Hf₁₋ₓCeₓO_{y} were determined. Specifically, the value of x was determined by calculating the ratio of the element concentration of Ce to the element concentration of Hf and the element concentration of Ce. The value of y was determined by calculating the ratio of the element concentration of O to the element concentration of Hf and the element concentration of Ce. Table 1 lists the results.

### (Evaluation of Dielectric Characteristics)

Using a ferroelectric tester Premier II manufactured by Radiant Technologies, Inc., after the upper electrode was formed, Polarization-Electric field measurement was performed on the dielectric film according to each sample to obtain a P-E curve of the dielectric film according to each sample. Based on this P-E curve, the dielectric characteristics of the dielectric films according to the examples and the comparative examples were evaluated. A case in which the dielectric film showed ferroelectricity was evaluated to be "A", and a case in which it showed paraelectricity was evaluated to be "B". Table 1 lists the results.

### (Evaluation of Crystalline Phase)

Crystalline phases contained in the dielectric films according to Examples 1 to 3 were evaluated using an X-ray diffraction apparatus X'Pert PRO MPD from Malvern Panalytical Ltd. Before the upper electrode was formed, X-ray diffraction measurement was performed on the dielectric films according to Examples 1 to 3 to obtain an XRD pattern of each dielectric film by 2θ/θ scan. In this measurement, the Cu-Kα line was used as an X-ray source. Subsequently, analysis software Data Viewer attached to the above apparatus was used for the XRD pattern to calculate the peak area a and the peak area b by the above method. Subsequently, a/(a + b) was calculated. The peak area a is the peak area of the diffraction peak attributed to reflection from the (111) plane in the XRD spectrum of the dielectric. The peak area b is the peak area of the diffraction peak attributed to reflection from the (001) plane in the XRD spectrum of the dielectric. Specifically, the value of a was determined by calculating the area of the peak observed near 2θ = 30.2°. The value of b was determined by calculating the area of the peak observed near 2θ = 35.4°. Table 1 lists the results.

As listed in Table 1, the dielectrics according to Examples 1 to 3 showed ferroelectricity. In the dielectrics according to Examples 1 to 3, 0.031 ≤ x ≤ 0.052 and 0 < y ≤ 1.50 were satisfied in the composition formula Hf₁₋ₓCeₓO_{y}. It is understood that the dielectrics according to Examples 1 to 3 were reduced in the addition concentration of Ce and thus improved in chemical stability.

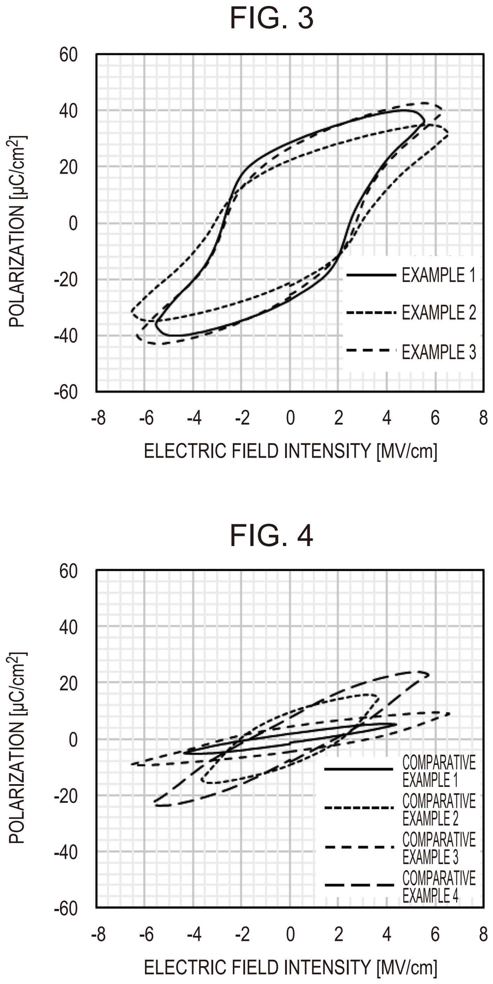

Fig. 3 is a graph of a relation between polarization and electric field intensity in the dielectric films according to Examples 1 to 3. In Fig. 3, the vertical axis shows polarization and the horizontal axis shows electric field intensity. As shown in Fig. 3, in the dielectric films according to Examples 1 to 3, the polarization was not 0 µC/cm² when the electric field intensity was 0 MV/cm, with residual polarization observed. That is, the dielectrics according to Examples 1 to 3 showed ferroelectricity.

Fig. 4 is a graph of a relation between polarization and electric field intensity in the dielectric films according to Comparative Examples 1 to 4. In Fig. 4, the vertical axis shows polarization and the horizontal axis shows electric field intensity. As shown in Fig. 4, in the dielectric films according to Comparative Examples 1 to 4, the polarization was not 0 µC/cm² when the electric field intensity was 0 MV/cm. This polarization was polarization derived from a leak current. The dielectric films according to Comparative Examples 1 to 4 did not show ferroelectricity. The dielectrics according to Comparative Examples 1 to 4 had paraelectricity.

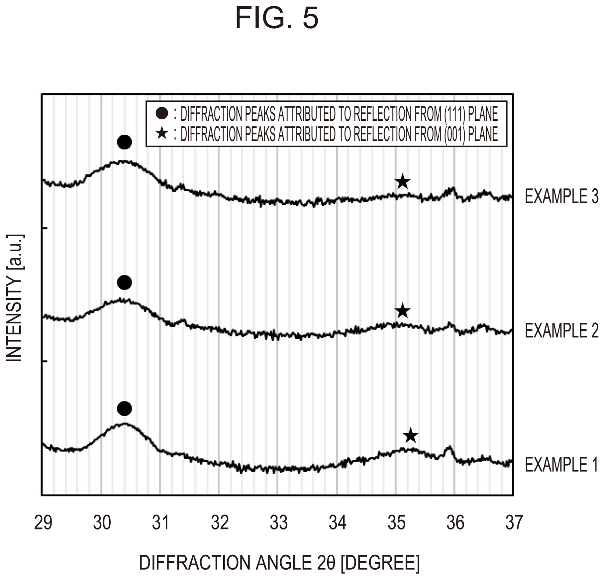

Fig. 5 is a graph of X-ray diffraction patterns of the dielectrics according to Examples 1 to 3. As shown in Fig. 5, in the dielectric films according to Examples 1 to 3, peaks were observed near 2θ = 30.2° and near 2θ = 35.4°. In addition, as listed in Table 1, in Examples 1 to 3, 0.87 ≤ a/(a + b) ≤ 0.98 was satisfied. These results show that the dielectrics used in Examples 1 to 3 were excellent in view of exhibiting ferroelectricity.

**[Table 1]**

| | x | y | Dielectric characteristics* | a/(a + b) |
|---|---|---|---|---|
| Example 1 | 0.031 | 1.44 | A | 0.87 |
| Example 2 | 0.048 | 1.47 | A | 0.97 |
| Example 3 | 0.052 | 1.50 | A | 0.98 |
| Comparative Example 1 | 0 | 1.56 | B | - |
| Comparative Example 2 | 0.019 | 1.54 | B | - |
| Comparative Example 3 | 0.048 | 1.57 | B | - |
| Comparative Example 4 | 0.096 | 1.57 | B | - |

| | | | | |
|---|---|---|---|---|
| *A: ferroelectricity, B: paraelectricity | | | | |

### Industrial Applicability

The dielectric of the present disclosure is advantageous from the viewpoint of improving chemical stability.

### Reference Signs List

- 1a, 1b: functional element
- 10: dielectric
- 21: first electrode
- 22: second electrode
- 23: electrolyte

## Claims

1. A dielectric comprising:
an oxide containing hafnium and cerium, wherein
a molar ratio of a content of cerium to a sum of a content of hafnium and the content of cerium is greater than or equal to 0.031 and less than or equal to 0.052, and
a molar ratio of a content of oxygen to the sum is greater than 0 and less than or equal to 1.50.

2. The dielectric according to claim 1, wherein the molar ratio of the content of oxygen to the sum is greater than or equal to 1.44 and less than or equal to 1.50.

3. The dielectric according to claim 1, wherein the dielectric has a composition represented by a composition formula Hf₁₋ₓCeₓO_{y} and satisfies 0.031 ≤ x ≤ 0.052 and y ≤ 1.50.

4. The dielectric according to claim 3, wherein the dielectric satisfies 1.44 ≤ y ≤ 1.50.

5. The dielectric according to claim 1, wherein
the dielectric contains a crystalline phase having a fluorite type crystal structure, and
the dielectric is a polycrystalline film.

6. The dielectric according to claim 1, wherein
the dielectric contains an orthorhombic crystalline phase, and
the dielectric satisfies 0.87 ≤ a/(a + b) ≤ 0.98 in an X-ray diffraction pattern of the dielectric, where
a is a peak area of a diffraction peak attributed to reflection from a (111) plane of the orthorhombic crystalline phase in the X-ray diffraction pattern, and
b is a peak area of a diffraction peak attributed to reflection from a (001) plane of the orthorhombic crystalline phase in the X-ray diffraction pattern.

7. A functional element comprising:
a first electrode;
a second electrode; and
the dielectric according to any one of claims 1 to 6, the dielectric being located between the first electrode and the second electrode.

8. The functional element according to claim 7, wherein at least part of the first electrode is porous.

9. The functional element according to claim 7, wherein the first electrode contains at least one selected from the group consisting of a metal, a conductive nitride, and a conductive oxide.

10. The functional element according to claim 7, wherein the first electrode contains at least one selected from the group consisting of Pt, Au, Al, Ta, and Zr.

11. The functional element according to claim 7, wherein the first electrode contains Al.

12. The functional element according to claim 7, further comprising:
an electrolyte located between the second electrode and the dielectric, wherein
the electrolyte contains at least one selected from the group consisting of an electrolyte solution, a conductive polymer, and manganese oxide.

13. The functional element according to claim 7, wherein the functional element is at least one selected from the group consisting of a capacitor, an electro-optic element, a memory element, a transistor, a ferroelectric data storage, a piezoelectric element, and a pyroelectric element.

14. The functional element according to claim 7, wherein
the dielectric is in contact with the first electrode, and
the second electrode covers at least part of the dielectric.
